# EUROPEAN PATENT SPECIFICATION

(11) **EP 3 506 439 B1**
(45) Date of publication and mention of the grant of the patent: **31.03.2021**
(21) Application number: 17210685.8
(22) Date of filing: 27.12.2017
(51) Int. Cl.: H01S 5/34, H01S 5/20, H01S 5/22, H01S 5/227, H01S 5/32, H01S 5/40

(54) **QUANTUM CASCADE LASER**
QUANTENKASKADENLASER
LASER À CASCADE QUANTIQUE

(43) Date of publication of application: 03.07.2019
(73) Proprietor: KABUSHIKI KAISHA TOSHIBA, Minato-ku Tokyo 105-8001 (JP)
(72) Inventor: Saito, Shinji, Tokyo, 105-8001 (JP); Kakuno, Tsutomu, Tokyo, 105-8001 (JP); Hashimoto, Rei, Tokyo, 105-8001 (JP); Kaneko, Kei, Tokyo, 105-8001 (JP)
(74) Representative: Hoffmann Eitle

(56) References cited:
- US-A1- 2004 066 823
- US-A1- 2007 008 999
- US-A1- 2013 195 136

## Description

### FIELD

The embodiment of the invention relates to a quantum cascade laser.

### BACKGROUND

A quantum cascade laser (QCL) emits infrared laser light.

When a threshold electric current of a quantum cascade laser is reduced, the quantum efficiency or light output can be raised.

However, quantum cascade lasers have an active layer in which a large number of light-emitting quantum well regions are cascade-connected thereon. Therefore, it cannot be said that optical confinement is sufficient in the direction perpendicular to a thick active layer, and it is not easy to reduce the threshold electric current.

US 2004/066823 A1 discloses a monolithic apparatus having a laser optical cavity. The laser optical cavity has a multi-layer structure that includes a first active semiconductor multi-layer and a second semiconductor multi-layer. The second semiconductor multi-layer is located laterally adjacent to the first active semiconductor multi-layer. The first active semiconductor multi-layer includes a sequence of quantum well structures that produce light of a lasing frequency in response to being electrically pumped. The second semiconductor multi-layer includes a sequence of quantum well structures and is configured to both absorb light of the lasing frequency and produce one of parametric light and harmonic light in response to absorbing light of the lasing frequency.

US 2013/195136 A1 discloses a semiconductor laser including: a stacked body having an active layer including a quantum well layer, the active layer having a cascade structure including a first region capable of emitting infrared laser light with a wavelength of not less than 12 mum and not more than 18 mum by an intersubband optical transition of the quantum well layer and a second region capable of relaxing energy of a carrier alternately stacked, the stacked body having a ridge waveguide and being capable of emitting the infrared laser light; and a dielectric layer provided so as to sandwich both sides of at least part of side surfaces of the stacked body, a wavelength at which a transmittance of the dielectric layer decreases to 50% being 16 mum or more, the dielectric layer having a refractive index lower than refractive indices of all layers constituting the active layer.

US 2007/008999 A1 discloses interband cascade lasers having high-refractive index semiconductor spacer layers within the active regions. Together with spacer layers which may be provided outside the active regions, broadened waveguides are formed which increase brightness and decrease divergence of the lasers. In one embodiment, current may be supplied laterally through the high-refractive index spacer layers. Carriers may be injected vertically through the active region from these contact layers, allowing selective functionality of some or all of the active region cascaded stages.

### Summary

The present invention provides a quantum cascade laser in accordance with claim 1.

### BRIEF DESCRIPTION OF THE DRAWINGS

FIG. 1A is a graph for describing light confinement in a vertical direction of the quantum cascade laser according to the first embodiment, and FIG. 1B is a graph showing the energy level of a conduction band;
FIG. 2A is a graph for describing light confinement in a vertical direction of the quantum cascade laser according to a first comparative example, and FIG. 2B is a graph for describing light confinement in a vertical direction of the quantum cascade laser according to a second comparative example;
FIG. 3A is a schematic perspective view of the quantum cascade laser according to the first embodiment, and FIG. 3B is a schematic cross-sectional view along the A-A line;
FIG. 4A is a graph showing the simulation results of relative light intensity distribution in a first specific example of the first embodiment, and FIG. 4B is a graph showing the simulation results of threshold electric current dependency with respect to the thickness of an optical guide layer;
FIG. 5 is a graph showing the simulation results of relative light intensity distribution in a specific example of a second comparative example;
FIG. 6A is a graph showing the simulation results of relative light intensity distribution in a second specific example of the first embodiment, and FIG. 6B is a graph showing the simulation results of threshold electric current dependency with respect to the thickness of an optical guide layer; and
FIG. 7A is a graph showing the simulation results of relative light intensity distribution in a third specific example of the first embodiment, and FIG. 7B is a graph showing the simulation results of threshold electric current dependency with respect to the thickness of an optical guide layer.

### DETAILED DESCRIPTION

In general, according to one embodiment, a quantum cascade laser of the embodiment has an active layer, a first and second cladding layer, and an optical guide layer. The active layer has a plurality of injection quantum well regions and a plurality of light-emitting quantum well regions. Each of the injection quantum well regions and each of the light-emitting quantum well regions are alternatively stacked. The each of the light-emitting quantum well regions emit laser light by optical transition between sub-bands of a carrier. The each of the injection quantum well regions mitigate the carrier after optical transition between sub-bands to a mini-band level, and inject the carrier into the light-emitting quantum well region which is downstream. The first and second cladding layers are provided to interpose the active layer from both sides, and have a refractive index lower than an effective refractive index of each of the light-emitting quantum well regions. The optical guide layer is disposed to divide the active layer into two parts in a stacking direction. The optical guide layer has a refractive index higher than the effective refractive index of the each of the light-emitting quantum well regions, and has a thickness greater than the thickness of all well layers of quantum well layers of the each of the light-emitting quantum well regions.

Hereinafter, embodiments of the invention will be described below with reference to drawings.

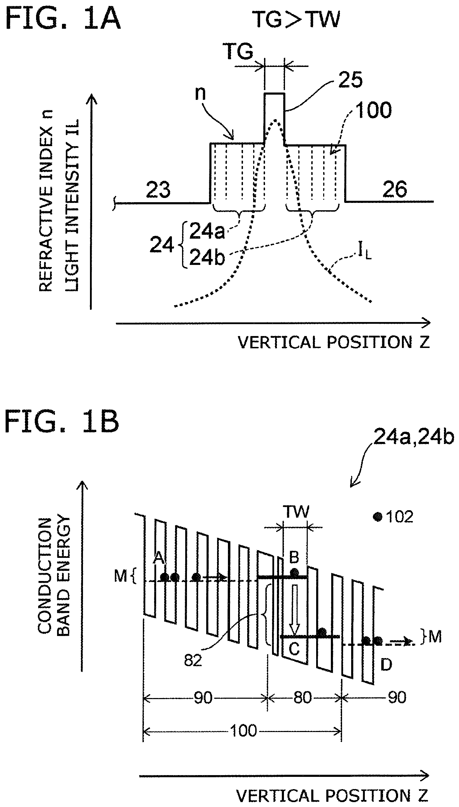

FIG. 1A is a graph for describing light confinement in a direction perpendicular to the active layer of the quantum cascade laser according to the first embodiment, and FIG. 1B is a graph showing the energy level of a conduction band.

In FIG. 1A, the vertical axis shows a refractive index n (solid line) and light intensity I_{L} (dotted line), and the horizontal axis Z shows the vertical (stacking direction) position of a semiconductor layer. As shown in FIG. 1A, the quantum cascade laser of the first embodiment has an active layer 24 (24a, 24b), a first cladding layer 23, a second cladding layer 26, and an optical guide layer 25.

In FIG. 1B, the vertical axis shows a conduction band energy level, and the horizontal axis Z shows a vertical position. As shown in FIG. 1B, the active layer 24 has a plurality of injection quantum well regions 90 and a plurality of light-emitting quantum well regions 80. The active layer 24 includes a stacked body having each injection quantum well region 90 and each light-emitting quantum well region 80 alternatively stacked thereon. That is, a unit stacked body 100 is arranged, including a pair of one injection quantum well region 90 and one light-emitting quantum well region 80. That is, each of the regions interposed by the broken lines in FIG 1(a) corresponds to the unit stacked body 100.

The number arranged is, for example, 30 to 200 or the like. Each light-emitting quantum well region 80 emits laser light by optical transition between sub-bands of a carrier 102 such as an electron. Furthermore, each injection quantum well region 90 mitigates the carrier 102 after optical transition between sub-bands to a mini-band level M, and injects it into the light-emitting quantum well region 80 which is downstream. As shown in FIG. 1B, when the carrier 102 is an electron, the electron is mitigated at a mini-band M of the injection quantum well region 90 (level A→B), emits laser light by transition between sub-bands in the light-emitting quantum well region 80 (level B→C), and is mitigated after being injected into the injection quantum well region 90 which is downstream (level D).

The optical guide layer 25 has a refractive index higher than the effective refractive index of each light-emitting quantum well region 80. The thickness of a well layer and thickness of a barrier layer of the light-emitting quantum well region 80 are sufficiently shorter than the wavelength of the laser light. Therefore, the effective refractive index of the light-emitting quantum well regions 80 is considered such that the medium, which is an intermediary refractive index between the refractive index of the well layer and the refractive index of the barrier layer that is lower than the refractive index of the well layer, is uniformly dispersed. Generally, a substance having a higher refractive index tends to have a lower band gap energy Eg. Even in this system, the band gap energy of the optical guide layer 25 may be lower than the band gap energy of the quantum well layer. In a pn-junction laser diode, a substance having a small band gap energy Eg becomes a light-absorbing layer, so there is no optical guide layer provided on the central portion of the active layer. However, quantum cascade lasers emit light at a lower energy than band gap energy, so light absorption is suppressed even if a substance having a high refractive index is provided on the central portion of the active layer 25.

It is favorable for the optical guide layer 25 to not include quantum wells that generate optical transition between bands. Therefore, the optical guide layer 25 has a thickness TG, which is respectively larger than the thickness of all of the well layers from among the quantum well layers of each light-emitting quantum well region 80. Note that in FIG. 1B, one light-emitting quantum well region 80 has two quantum well layers, and when the thickness of the larger well layer is expressed as TW: TG>TW. Note that if the thickness TG of the optical guide layer 25 is 100 nm or greater, the light confinement effect can be raised, as described using a simulation hereinafter. On the other hand, if the active layer 24a and the active layer 24b are separated too much, the optical feedback effect is lessened. Therefore, it is favorable for the thickness TG of the optical guide layer 25 to be 500 nm or less.

Moreover, it is favorable for the optical guide layer 25 to be provided to divide the active layer 24 into two substantially equal parts because this makes it so that the light intensity distribution can be close to symmetrical. For example, if the number of cascade-connected unit stacked bodies 100 is an even number, the optical guide layer 25 may be provided to divide the stacked number of unit stacked bodies 100 into two equal parts. Furthermore, if the stacked number of unit stacked bodies 100 is an odd number, one of the sides becomes slightly larger. However, because the stacked number of unit stacked bodies 100 is large at 30 to 200 or the like, it does not strictly need to be divided in two.

The first cladding layer 23 and the second cladding layer 26 are provided to interpose the active layer 24 from both sides. The refractive index of the first and second cladding layers 23 and 26 is lower than the effective refractive index of each light-emitting quantum well region.

In the first embodiment, the light confinement effect can be strengthened by disposing the optical guide layer 25 around the vicinity of the central portion of the active layer 24. Therefore, the threshold electric current is reduced, and the quantum efficiency and light output can be raised.

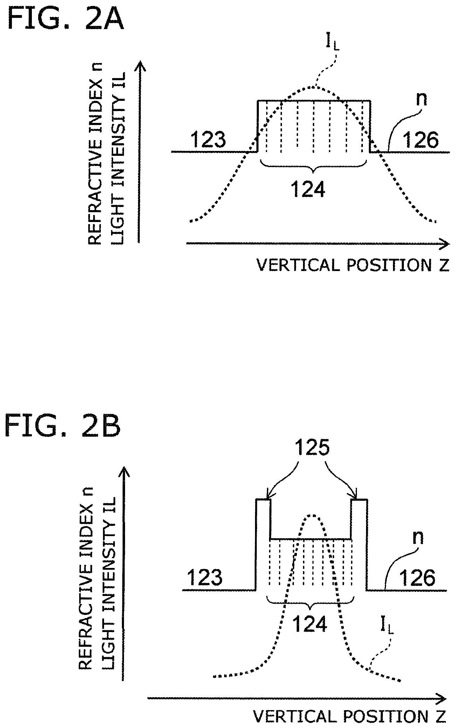

FIG. 2A is a graph for describing the light confinement effect in a direction perpendicular to the active layer of the quantum cascade laser according to a first comparative example, and FIG. 2B is a graph for describing the light confinement effect in a direction perpendicular to the active layer of the quantum cascade laser according to a second comparative example.

In FIGS. 2A and 2B, the vertical axis is the refractive index n and light intensity I_{L}, and the horizontal axis is the vertical position Z. In the quantum cascade laser of the first comparative example shown in FIG. 2A, an active layer 124 is interposed by a first cladding layer 123 and a second cladding layer 126, and an optical guide layer having an effective refractive index higher than the refractive index of the injection quantum well region and the refractive index of the light-emitting quantum well region is not provided. Therefore, the light confinement effect is weak, and the distribution of light intensity I_{L} expands to within the active layer 124. Because of this, the threshold electric current cannot be reduced, and it is difficult to achieve high output.

In the quantum cascade laser of the second comparative example shown in FIG. 2B, a optical guide layer 125 having a refractive index higher than the effective refractive index of each of the light-emitting quantum well regions is provided between the active layer 124 and the first cladding later 123, and between the active layer 124 and the second cladding layer 126. Because the optical guide layer 125 is provided, the light confinement effect can be strengthened more than in the first comparative example, but the light confinement effect is less than in the first embodiment, wherein the optical guide layer 125 is disposed in the central portion. Note that the light confinement effect will be described in detail later using the simulation results.

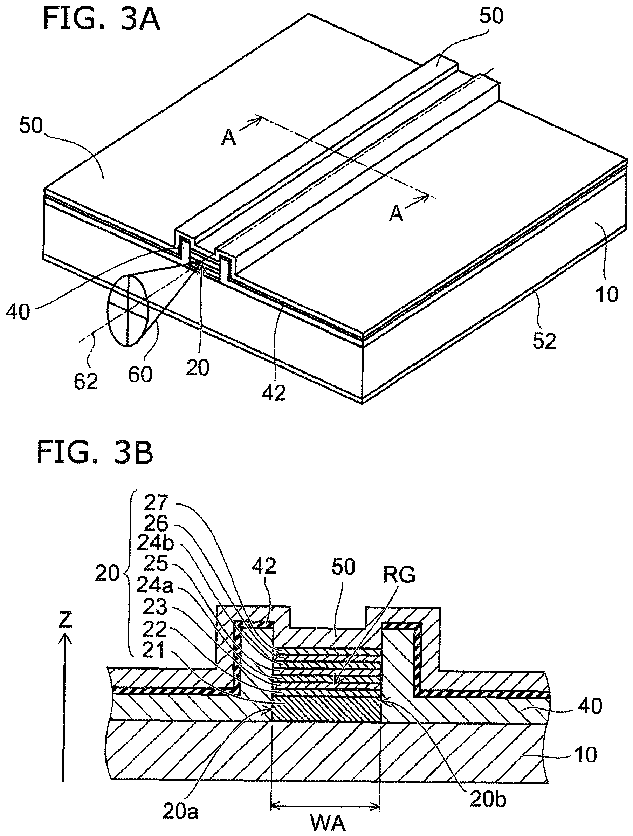

FIG. 3A is a schematic perspective view of the quantum cascade laser according to the first embodiment, and FIG. 3B is a schematic cross-sectional view along the A-A line.

The quantum cascade laser can further have a substrate 10, and a stacked body 20 is further provided, crystal grown using a metal organic chemical vapor deposition (MOCVD) method or a molecular beam epitaxy (MBE) method. The stacked body 20 is processed by a stripe-shaped ridge wave guide RG. Additionally, dielectric layers 40 and 42 are provided to cover the substrate 10 and the stacked body 20. The dielectric layers 40 and 42 are opened so that the upper surface of the stacked body 20 is exposed, and a first electrode 50 is provided. Furthermore, a second electrode 52 is provided on the back surface of the substrate 10.

A width WA of the ridge waveguide RG is, for example, 10 to 50 µm or the like. Note that in FIG. 3B, a cross-section of the ridge waveguide RG is shown by rectangles having side surfaces 20a and 20b. However, the shape of the ridge waveguide RG is not limited to this, and may be mesa-shaped.

The stacked body 20 has a foundation layer 21, a contact layer 22, the first cladding layer 23, the active layer 24a, the optical guide layer 25, the active layer 24b, the second cladding layer 26, and a contact layer 27, in this order from the side of the substrate 10.

As illustrated in FIG. 3A, laser light 60 having an infrared/terahertz wavelength is emitted from the edge surface of the active layer 24 along an optical axis 62.

Next, the light intensity distribution and threshold electric current calculated by a simulation will be described as a specific example. The substrate 10 includes InP or GaAs, and the light-emitting quantum well regions 80 are well layers including InₓGa₁₋ₓAs (0<x<1), and barrier layers including In_{y}Al_{1-y}As (0<y<1). Furthermore, the optical guide layer 25 includes In_{z}Ga_{1-z}As (0<z<1).

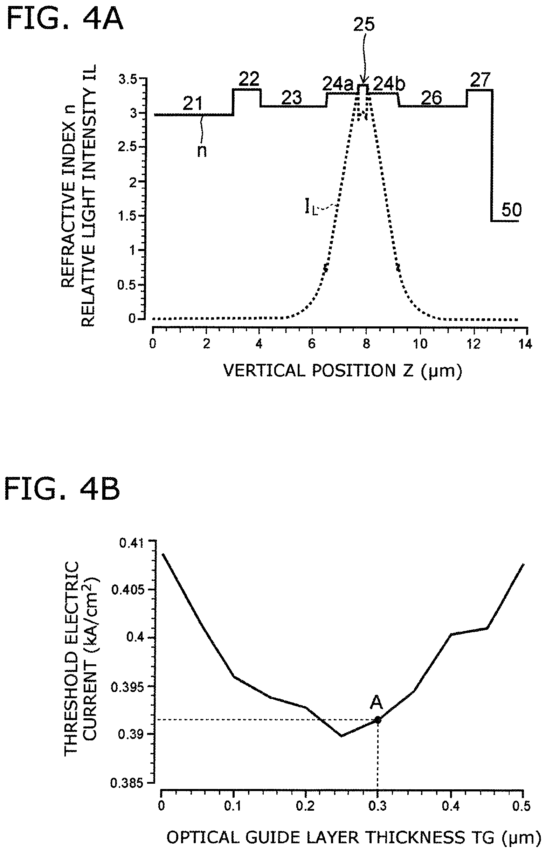

FIG. 4A is a graph showing the simulation results of relative light intensity distribution in a first specific example of the first embodiment, and FIG. 4B is a graph showing the simulation results of threshold electric current dependency with respect to the thickness of the optical guide layer.

In FIG. 4A, the vertical axis is the refractive index (solid line) n or light intensity (broken line) I_{L}, and the horizontal axis is the vertical position Z.

(Table 1) shows the unit stacked body 100 of the first specific example.

**[Table 1]**

| Reference Numeral | Layer | Composition | Thickness (µm) | Doping (x10¹⁷cm⁻²) | Refractive index |
|---|---|---|---|---|---|
| 21 | Foundation Layer | InP | 3 | 30 | 2.967+j1.515E-02 |
| 22 | Contact Layer | In₀.₅₃₂Ga₀.₄₆₈As | 1 | 10 | 3.336+j7.9E-03 |
| 23 | Cladding Layer | InP | 2.5 | 0.4 | 3.089+j1.94E-04 |
| 24a | Active layer | InGaAs/InAlAs | 1.1895 | 0.1 | 3.263+j1.199E-04 |
| 25 | Optical Guide Layer | In₀.₅₃₂Ga₀.₄₆₈As | 0.3 | 0 | 3.402 |
| 24b | Active layer | InGaAs/InAlAs | 1.1895 | 0.1 | 3.263+j1.199E-04 |
| 26 | Cladding Layer | InP | 2.5 | 0.4 | 3.089+j1.94E-04 |
| 27 | Contact Layer | In₀.₅₃₂Ga₀.₄₆₈As | 1.0 | 10 | 3.336+j7.9E-03 |
| 50 | Upper Electrode | Au | 1.0 | | 1.425+j3.222E-01 |

The stacked body 20 has the foundation layer 21 including n-type InP (thickness: 3 µm, refractive index: 2.97), the contact layer 22 including n-type InGaAs (thickness: 1 µm, refractive index: 3.34), the first cladding layer 23 including n-type InP (thickness: 2.5 µm, refractive index: 3.09), the active layer 24a (thickness: 1.19 µm, refractive index: 3.26), the optical guide layer 25 including InGaAs (thickness: 0.3 µm, refractive index: 3.4), the active layer 24b (thickness: 1.19 µm, refractive index: 3.26), the second cladding later 26 including n-type InP (thickness: 2.5 µm, refractive index: 3.09), and the contact layer 27 including n-type InGaAs (thickness: 1 µm, refractive index: 3.34), in this order from the side of the substrate 10. Note that the foundation layer 21 may be a portion of the substrate 10. Note that when configuring the contact layers 22 and 27, the optical guide layer 25, the active layers 24a and 24b, and the like by InₓGa₁₋ₓAs (0<x<1), when the mole ratio x approaches 0.523, lattice match with InP becomes easier, and crystallinity becomes favorable.

As shown in FIG. 1B, the light-emitting quantum well regions 80 can have two or more well layers. For example, the well layer thickness TW of the thicker one is 4.5 nm or the like. The thickness TG of the optical guide layer 25 is 0.3 µm, and is sufficiently thicker than the well layer thickness TW. Therefore, optical transition between sub-bands does not occur in the optical guide layer 25. That is, the electron that is the carrier 102 is confined in a well layer of the light-emitting quantum well region 80. On the other hand, light is confined near the optical guide layer 25 having a refractive index higher than the effective refractive index of the light-emitting quantum well layers 80. If the well layer thickness TW is made to be 4.5 nm, the peak of gain is an infrared band such as near 3.7 µm or near 4.3 µm.

As shown in FIG. 4A, the spreading width (stacking direction) of the laser beam in which the light intensity I_{L} is half of the peak value can be made narrow at approximately 1.8 µm. Therefore, as shown in point A of FIG. 4B, the threshold electric current can be made low at approximately 0.392 kA/cm². Because of this, the quantum efficiency and light output can be raised. Furthermore, warping may be introduced to the light-emitting quantum well regions 80. For example, the well layer can be made In_{0.669}Ga_{0.331}As (the lattice constant number is larger than InP), and the barrier layer can be made In_{0.362}AI₀.₆₃₈As (the lattice constant number is smaller than InP), or the like. When done in this manner, for example, lattice mismatch is compensated for between the well layer and the barrier layer, so crystallinity can be maintained in a favorable manner, and the threshold electric current can be further reduced.

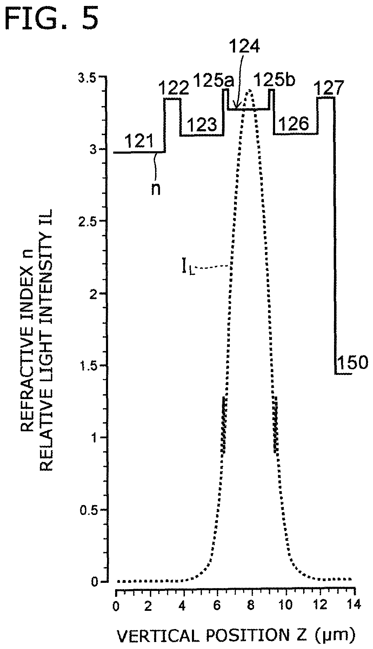

FIG. 5 is a graph showing the simulation results of relative light intensity distribution in the second comparative example.

In FIG. 5, the vertical axis is the refractive index (solid line) n or light intensity (broken line) I_{L}, and the horizontal axis is the position Z in the vertical direction.

(Table 2) shows the unit stacked body of the second comparative example.

**[Table 2]**

| Reference Numeral | Layer | Composition | Thickness (µm) | Doping (×10¹⁷cm⁻²) | Refractive index |
|---|---|---|---|---|---|
| 121 | Foundation Layer | InP | 3 | 30 | 2.967+j1.515E-02 |
| 122 | Contact Layer | In_{0.532}Ga_{0.468}As | 1 | 10 | 3.336+j7.9E-03 |
| 123 | Cladding Layer | InP | 2.5 | 0.4 | 3.089+j1.94E-04 |
| 125a | Optical guide layer | In_{0.532}Ga_{0.468}As | 0.3 | 1.0 | 3.395+j7.764E-04 |
| 124 | Active layer | InGaAs/InAlAs | 2.38 | 0.1 | 3.263+j1.199E-04 |
| 125b | Optical Guide Layer | In_{0.532}Ga_{0.468}As | 0.3 | 1.0 | 3.395+j7.764E-04 |
| 126 | Cladding Layer | InP | 2.5 | 0.4 | 3.089+j1.94E-04 |
| 127 | Contact Layer | In_{0.532}Ga_{0.468}As | 1.0 | 10 | 3.336+j7.9E-03 |
| 150 | Upper Electrode | Au | 1.0 | | 1.425+j3.222E-01 |

The stacked body includes a foundation layer 121 including n-type InP (thickness: 3 µm, refractive index: 2.97), a contact layer 122 made of n-type InGaAs (thickness: 1 µm, refractive index: 3.34), the first cladding layer 123 including n-type InP (thickness: 2.5 µm, refractive index: 3.09), a optical guide layer 125a (thickness: 0.3 µm, refractive index: 3.40), the active layer 124 (thickness: 2.38 µm, refractive index: 3.26), a optical guide layer 125 b (thickness: 0.3 µm, refractive index: 3.40), the second cladding later 126 including n-type InP (thickness: 2.5 µm, refractive index: 3.09), and a contact layer 127 including n-type InGaAs (thickness: 1.0 µm, refractive index: 3.34), in this order from the side of the substrate.

The spreading width (stacking direction) of the laser beam in which the light intensity I_{L} is half of the peak value becomes wide at approximately 2.29 µm. Because of this, the threshold electric current becomes large at approximately 0.498 kA/cm², and the quantum efficiency and light output are reduced lower than in the first specific example.

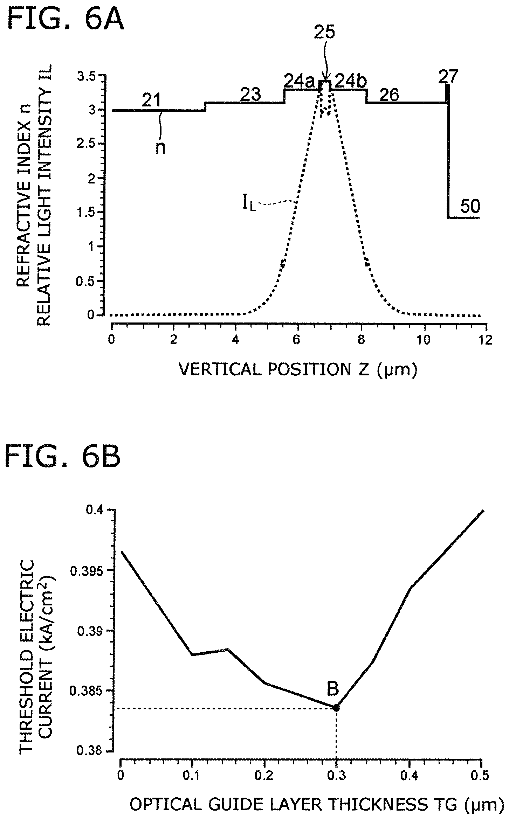

FIG. 6A is a graph showing the simulation results of relative light intensity distribution in the second specific example of the first embodiment, and FIG. 6B is a graph showing the simulation results of threshold electric current dependency with respect to the thickness of a optical guide layer.

In FIG. 6A, the vertical axis shows the refractive index (solid line) n or light intensity (broken line) I_{L}, and the horizontal axis shows the vertical position Z.

(Table 3) shows the unit stacked body 100 of the second specific example.

**[Table 3]**

| Reference Numeral | Layer | Composition | Thickness (µm) | Doping (×10¹⁷cm⁻²) | Refractive index |
|---|---|---|---|---|---|
| 21 | Foundation Layer | InP | 3 | 30 | 2.967+j1.515E-02 |
| 23 | Cladding Layer | InP | 2.5 | 0.4 | 3.089+j1.94E-04 |
| 24a | Active layer | InGaAs/InAlAs | 1.1895 | 0.1 | 3.263+j1.199E-04 |
| 25 | Optical Guide Layer | In_{0.532}Ga_{0.468}As | 0.3 | 0 | 3.402 |
| 24b | Active layer | InGaAs/InAlAs | 1.1895 | 0.1 | 3.263+j1.199E-04 |
| 26 | Cladding Layer | InP | 2.5 | 0.4 | 3.089+j1.94E-04 |
| 27 | Contact Layer | In_{0.532}Ga_{0.468}As | 0.1 | 10 | 3.336+j7.9E-03 |
| 50 | Upper Electrode | Au | 1.0 | | 1.425+j3.222E-01 |

In the stacked body 20, the foundation layer 21 including n-type InP (thickness: 3 µm, refractive index: 2.97), the first cladding layer 23 including n-type InP (thickness: 2.5 µm, refractive index: 3.09), the active layer 24a (thickness: 1.19 µm, refractive index: 3.26), the optical guide layer 25 (thickness: 0.3 µm, refractive index: 3.4), the active layer 24b (thickness: 1.19 µm, refractive index: 3.26), the second cladding later 26 including n-type InP (thickness: 2.5 µm, refractive index: 3.09), and the contact layer 27 including n-type InGaAs (thickness: 0.1 µm, refractive index: 3.34), are disposed from the side of the substrate 10.

As shown in FIG. 6A, the spreading width (stacking direction) of the laser beam in which the light intensity I_{L} is half of the peak value can be made narrow at approximately 1.8 µm. Therefore, as shown in point B of FIG. 6B, the threshold electric current can be made low at approximately 0.384 kA/cm². Because of this, the quantum efficiency and light output can be raised.

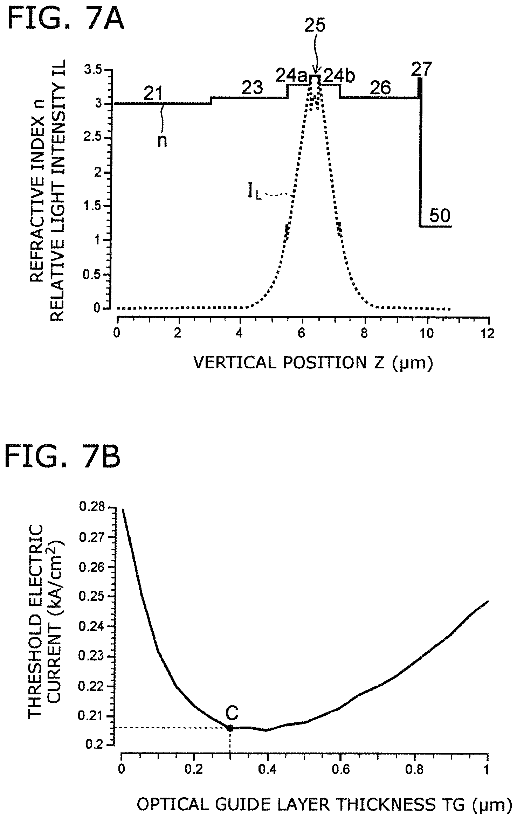

FIG. 7A is a graph showing the simulation results of relative light intensity distribution in a third specific example of the first embodiment, and FIG. 7B is a graph showing the simulation results of threshold electric current dependency with respect to the thickness of a optical guide layer.

In FIG. 7A, the vertical axis shows the refractive index (solid line) n or light intensity (broken line) I_{L}, and the horizontal axis shows the vertical position Z.

(Table 4) shows the unit stacked body of the third specific example 3.

**[Table 4]**

| Reference Numeral | Layer | Composition | Thickness (µm) | Doping (×10¹⁷cm⁻²) | Refractive index |
|---|---|---|---|---|---|
| 21 | Foundation Layer | InP | 3 | 30 | 2.967+j1.515E-02 |
| 23 | Cladding Layer | InP | 2.5 | 0.4 | 3.089+j1.94E-04 |
| 24a | Active layer | InGaAs/InAlAs | 0.6885 | 0.17 | 3.263+j1.199E-04 |
| 25 | Optical Guide Layer | In_{0.532}Ga_{0.468}As | 0.3 | 0 | 3.402 |
| 24b | Active layer | InGaAs/InAlAs | 0.6885 | 0.17 | 3.263+j1.199E-04 |
| 26 | Cladding Layer | InP | 2.5 | 0.4 | 3.089+j1.94E-04 |
| 27 | Contact Layer | In_{0.532}Ca_{0.468}As | 0.1 | 10 | 3.336+j7.9E-03 |
| 50 | Upper Electrode | Au | 1.0 | | 1.425+j3.222E-01 |

The stacked body 20 includes the foundation layer 21 including n-type InP (thickness: 3 µm, refractive index: 2.97), the first cladding layer 23 including n-type InP (thickness: 2.5 µm, refractive index: 3.09), the active layer 24a (thickness: 0.69 µm, refractive index: 3.29), the optical guide layer 25 (thickness: 0.3 µm, refractive index: 3.42), the active layer 24b (thickness: 0.69 µm, refractive index: 3.29), the second cladding later 26 including n-type InP (thickness: 2.5 µm, refractive index: 3.09), and the contact layer 27 including n-type InGaAs (thickness: 0.1 µm, refractive index: 3.37) in this order from the side of the substrate 10.

As shown in FIG. 7A, the spreading width (stacking direction) of the laser beam in which the light intensity I_{L} is half of the peak value can be made narrow at approximately 1.27 µm. Therefore, as shown in point C of FIG. 7B, the threshold electric current can be made low at approximately 0.206 kA/cm². Because of this, the quantum efficiency and light output can be raised.

According to the embodiment, a quantum cascade laser is provided having a lower threshold electric current. By making a low threshold electric current, the quantum efficiency or light output of a quantum cascade laser can be raised. These quantum cascade lasers can be widely used for gas analysis, environment measurement, detection of dangerous substances, and the like.

## Claims

1. A quantum cascade laser comprising:
an active layer (24) including a plurality of injection quantum well regions (90) and a plurality of light-emitting quantum well regions (80), the each of the plurality of injection quantum well regions (90) and the each of the plurality of light-emitting quantum well regions (80) being alternatively stacked, the each of the plurality of light-emitting quantum well regions (80) emitting laser light by optical transition between sub-bands of a carrier, and the each of the plurality of injection quantum well regions (90) mitigating the carrier (102) after the optical transition between sub-bands to a mini-band level, and injecting the carrier (102) into a light-emitting quantum well region (80) downstream, the active layer (24) including a first portion (24a) and a second portion (24b), the first portion (24a) and the second portion (24b) being stacked upon each other, a thickness of the first portion (24a) and a thickness of the second portion (24b) being same, a refractive index of the first portion (24a) and a refractive index of the second portion (24b) being substantially same;
a first and a second cladding layer (23, 26) provided on both outer sides of the active layer (24), and having a refractive index lower than an effective refractive index of the each of the plurality of light-emitting quantum well regions (80); and
an optical guide layer (25) interposed between the first portion (24a) and the second portion (24b) in a stacking direction, having a refractive index higher than the effective refractive index of the each of the plurality of light-emitting quantum well regions (80), and having a thickness greater than thicknesses of all well layers of quantum well layers of the each of the plurality of light-emitting quantum well regions (80),
the quantum cascade laser emitting light at a lower energy than that of the bandgap of the optical guide layer such that light absorption in the optical guide layer is suppressed.

2. The laser according to claim 1, further comprising a substrate (10),
the first and the second cladding layers (23, 26) including a material that lattice-matches the substrate (10).

3. The laser according to one of Claim 1 or Claim 2, wherein the thickness of the optical guide layer (25) is 100 nm or greater and 500 nm or less.

4. The laser according to one of claims 1 - 3, wherein:
the substrate (10) includes InP,
the each of the plurality of light-emitting quantum well regions (80) includes a well layer including InₓGa₁₋ₓAs, where 0<x<1, and a barrier layer including In_{y}Al_{1-y}As, where 0<y<1,
the optical guide layer (25) includes In_{z}Ga_{1-z}As, where 0<z<1, and
the first cladding layer (23) and the second cladding layer (26) include InP.

## Patentansprüche

1. Ein Quantenkaskadenlaser, umfassend:
eine aktive Schicht (24), die eine Vielzahl von Injektionsquantentopfbereichen (90) und eine Vielzahl von lichtemittierenden Quantentopfbereichen (80) enthält, wobei jeder der Vielzahl von Injektionsquantentopfbereichen (90) und jeder der Vielzahl von lichtemittierenden Quantentopfbereichen (80) abwechselnd gestapelt ist, wobei jeder der Vielzahl von lichtemittierenden Quantentopfbereichen (80) Laserlicht durch optischen Übergang zwischen Unterbändern eines Trägers emittiert, und wobei jeder der Vielzahl von Injektionsquantentopfbereichen (90) den Träger (102) nach dem optischen Übergang zwischen Teilbändern auf ein Minibandniveau abschwächt, und den Träger (102) in einen lichtemittierenden Quantentopfbereich (80) stromabwärts zu injizieren, wobei die aktive Schicht (24) einen ersten Abschnitt (24a) und einen zweiten Abschnitt (24b) umfasst, wobei der erste Abschnitt (24a) und der zweite Abschnitt (24b) aufeinander gestapelt sind, wobei eine Dicke des ersten Abschnitts (24a) und eine Dicke des zweiten Abschnitts (24b) gleich sind, wobei ein Brechungsindex des ersten Abschnitts (24a) und ein Brechungsindex des zweiten Abschnitts (24b) im Wesentlichen gleich sind;
eine erste und eine zweite Mantelschicht (23, 26), die auf beiden Außenseiten der aktiven Schicht (24) vorgesehen sind und einen Brechungsindex aufweisen, der niedriger ist als ein effektiver Brechungsindex jedes der Vielzahl von lichtemittierenden Quantentopfbereichen (80); und
eine optische Führungsschicht (25), die zwischen dem ersten Abschnitt (24a) und dem zweiten Abschnitt (24b) in einer Stapelrichtung angeordnet ist, mit einem Brechungsindex, der höher ist als der effektive Brechungsindex jedes der Vielzahl von lichtemittierenden Quantentopfbereichen (80), und mit einer Dicke, die größer ist als die Dicken aller Topfschichten der Quantentopfschichten jedes der Vielzahl von lichtemittierenden Quantentopfbereichen (80),
wobei der Quantenkaskadenlaser Licht mit einer niedrigeren Energie als der der Bandlücke der optischen Führungsschicht emittiert, so dass die Lichtabsorption in der optischen Führungsschicht unterdrückt wird.

2. Der Laser nach Anspruch 1, ferner umfassend ein Substrat (10),
wobei die erste und die zweite Mantelschicht (23, 26) ein Material enthalten, das an das Substrat (10) gitterartig angepasst ist.

3. Der Laser nach einem der Ansprüche 1 oder 2, wobei die Dicke der optischen Führungsschicht (25) 100 nm oder mehr und 500 nm oder weniger beträgt.

4. Der Laser nach einem der Ansprüche 1 bis 3, wobei das Substrat (10) InP enthält,
jeder der Vielzahl von lichtemittierenden Quantentopfbereichen (80) eine Topfschicht mit InxGa1-xAs, wobei 0<x<1, und eine Sperrschicht mit In_{y}Al_{1-y}As, wobei 0<y<1, enthält,
die optische Führungsschicht (25) In_{z}Ga_{1-z}As enthält, wobei 0<z<1 ist, und
die erste Mantelschicht (23) und die zweite Mantelschicht (26) InP enthalten.

## Revendications

1. Laser à cascade quantique comprenant :
une couche active (24) incluant une pluralité de régions de puits quantique d'injection (90) et une pluralité de régions de puits quantique d'émission de lumière (80), les chacune de la pluralité de régions de puits quantique d'injection (90) et les chacune de la pluralité de régions de puits quantique d'émission de lumière (80) étant empilées alternativement, les chacune de la pluralité de régions de puits quantique d'émission de lumière (80) émettant de la lumière laser par transition optique entre des sous-bandes d'un support, et les chacune de la pluralité de régions de puits quantique d'injection (90) atténuant le support (102) après la transition optique entre des sous-bandes à un niveau de mini-bande, et injectant le support (102) dans une région de puits quantique d'émission de lumière (80) en aval, la couche active (24) incluant une première partie (24a) et une seconde partie (24b), la première partie (24a) et la seconde partie (24b) étant empilées l'une sur l'autre, une épaisseur de la première partie (24a) et une épaisseur de la seconde partie (24b) étant identiques, un indice de réfraction de la première partie (24a) et un indice de réfraction de la seconde partie (24b) étant sensiblement identiques ;
une première et une seconde couche de placage (23, 26) fournies sur les deux côtés extérieurs de la couche active (24), et présentant un indice de réfraction inférieur à un indice de réfraction réel des chacune de la pluralité de régions de puits quantique d'émission de lumière (80) ; et
une couche de guidage optique (25) interposée entre la première partie (24a) et la seconde partie (24b) dans une direction d'empilement, présentant un indice de réfraction supérieur à l'indice de réfraction réel des chacune de la pluralité de régions de puits quantique d'émission de lumière (80), et présentant une épaisseur supérieure à des épaisseurs de toutes les couches de puits de couches de puits quantique des chacune de la pluralité de régions de puits quantique d'émission de lumière (80),
le laser à cascade quantique émettant de la lumière à une énergie inférieure à celle de la bande interdite de la couche de guidage optique de sorte que l'absorption de lumière dans la couche de guidage optique soit supprimée.

2. Laser selon la revendication 1, comprenant en outre un substrat (10),
la première et la seconde couche de placage (23, 26) incluant un matériau qui correspond en réseau au substrat (10).

3. Laser selon l'une de la revendication 1 ou la revendication 2, dans lequel l'épaisseur de la couche de guidage optique (25) est de 100 nm ou plus et de 500 nm ou moins.

4. Laser selon l'une des revendications 1-3, dans lequel :
le substrat (10) inclut InP,
les chacune de la pluralité de régions de puits quantique d'émission de lumière (80) incluent une couche de puits incluant InₓGa₁₋ₓAs, où 0 < x <1, et une couche barrière incluant In_{y}Al_{1-y}As, où 0 < y < 1,
la couche de guidage optique (25) inclut In_{z}Ga_{1-z}As, où 0 < z < 1, et
la première couche de placage (23) et la seconde couche de placage (26) incluent InP.
